# EUROPEAN PATENT SPECIFICATION

(11) **EP 4 210 197 B1**
(45) Date of publication and mention of the grant of the patent: **06.08.2025**
(21) Application number: 22215735.6
(22) Date of filing: 22.12.2022
(51) Int. Cl.: H02J 7/00, B60L 53/302, H05K 7/20, B60L 53/14

(54) **CHARGER**
LADEGERÄT
CHARGEUR

(30) Priority: 30.12.2021 CN 202111664490
(43) Date of publication of application: 12.07.2023
(73) Proprietor: Nanjing Chervon Industry Co., Ltd., Nanjing, Jiangsu 211106 (CN)
(72) Inventor: CAO, Yafei, 211106 Nanjing, Jiangsu (CN); ZHANG, Yuexiang, 211106 Nanjing, Jiangsu (CN)
(74) Representative: Sun, Yiming

(56) References cited:
- WO-A1-2020/204534
- WO-A1-2021/129443
- US-A1- 2019 116 689
- US-A1- 2021 155 104
- US-A1- 2022 192 058
- US-A1- 2022 302 757

## Description

### TECHNICAL FIELD

The present invention relates to a charger and, in particular, to a high-power charger.

### BACKGROUND

When being charged, high-power chargers applied in the field of power tools generate a considerable amount of heat inside. If the generated heat cannot be dissipated in time, some important electronic elements in the high-power chargers will fail, thereby damaging the chargers and even battery packs.

Document WO 2021129443A1 discloses a wireless charging device (10) comprising a shell (100), a coil module (210), a main board module (220) and a heat dissipation assembly (300). Document US 2021155104A1 discloses an electric vehicle charger that may include power electronics, one or more controllers, and one or more cable/connector plugs. Document WO 2020204534A1 discloses a converter comprising: a housing; a heat-generating component disposed inside the housing; and a heat-dissipating module disposed on the heat-generating component.

### SUMMARY

To overcome the deficiencies of the related art, the present invention provides a charger which has high heat dissipation efficiency, a compact structure, and the function of high-power output as defined in the independent claim attached. Preferred embodiments of the invention are defined in dependent claims attached.

The present invention provides the charger, where the heat dissipation channel for the airflow to flow through is formed in the housing and includes at least the first channel and the second channel, the first channel has the first port facing the air inlet of the housing and the second port facing away from the air inlet, and the airflow flowing out of the fan enters the first channel from the first port, flows out from the second port, and enters the second channel. The second channel has a smaller cross-sectional area than the first port of the first channel so that the airflow flowing through the first port can accelerate through the second channel, thereby improving the heat dissipation efficiency of the whole charger.

### BRIEF DESCRIPTION OF THE DRAWINGS

FIG. 1 is a structure view of a charger as one of examples;
FIG. 2 is an exploded view of the charger in FIG. 1;
FIG. 3 is a sectional view of the charger in FIG. 1;
FIG.4 is a schematic diagram of a cross-sectional area of a first port of a first channel along a line A-A, and a schematic diagram of a cross-sectional area of a second channel along a line B-B.
FIG. 5 is a schematic view showing a positional relationship of a fan in a charger;
FIG. 6 is a partial exploded view of a fan;
FIG. 7 is a schematic view showing a use state of a charger as an example;
FIG. 8 is a structure view of the charger in FIG. 1 from another angle;
FIG. 9 is a structure view of the charger in FIG. 1 from another angle;
FIG. 10 is a structure view of a winding portion of a charger;
FIG. 11 is a view showing a specific structure of a charging device of a charger; and
FIG. 12 is a sectional view of a charging terminal in FIG. 11.

### DETAILED DESCRIPTION OF THE EMBODIMENTS

The present invention is described below in detail in conjunction with drawings and examples.

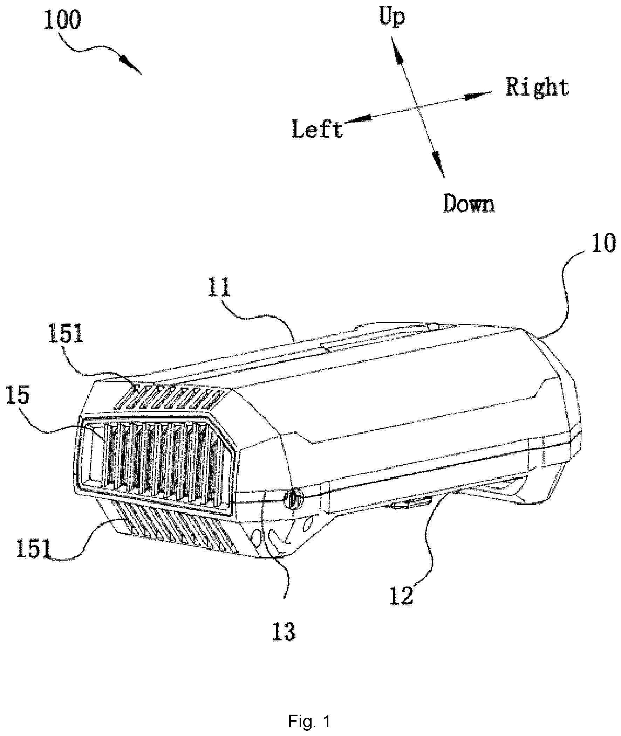

As shown in FIG. 1, a charger 100 as an example of the present invention can charge a battery pack. The battery pack may provide electrical energy for some handheld power tools such as electric drills and angle grinders. Of course, the battery pack may also provide electrical energy for large power tools, for example, garden tools such as smart mowers. The charger 100 in this example has relatively high output power and is particularly suitable for charging battery packs of some large power tools. In fact, the teachings of the present invention are applicable to any type of charger which charges battery packs.

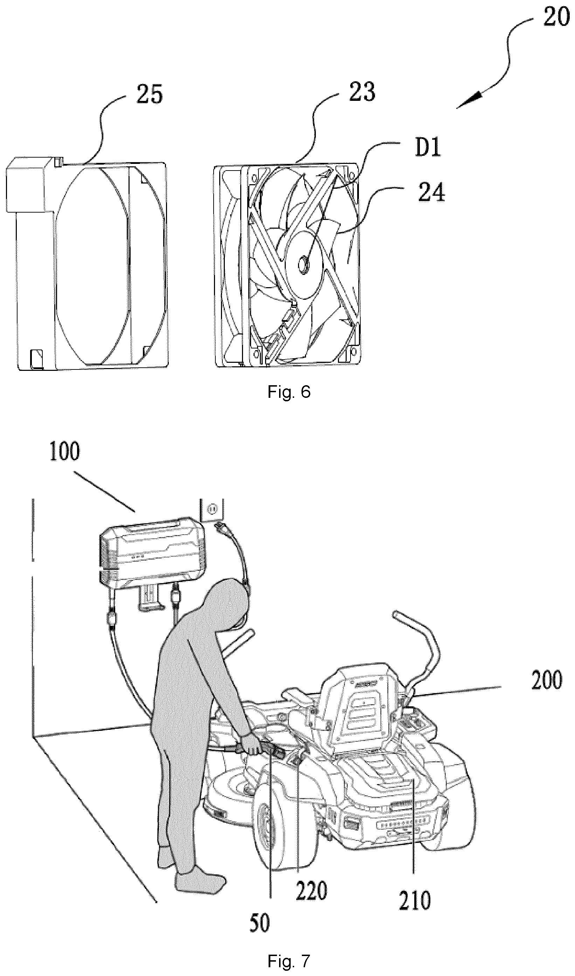

As shown in FIG.7, the charger 100 can charge a power tool with a plurality of battery parks, such as a riding mower 200. In some example, the charger 100 can charge a wheeled vehicle, such as a UTV (Utility Vehicle) or an ATV (All Terrain Vehicle).

As shown in FIGS. 1 to 3, the charger 100 includes a housing 10 assembled from an upper housing 11, a lower housing 12, a left housing 13, and a right housing 14, where an air inlet 15 for an airflow to flow through is disposed on the left housing 13 and an air outlet 16 for the airflow to flow through is disposed on the right housing 14. The airflow can flow into the housing 10 from the air inlet 15 on the housing 10 and flow out of the housing from the air outlet 16 on the housing 10. In some other examples, the housing may be assembled from an upper housing and a lower housing along an up and down direction, which may be understood as that parts of the left housing and the right housing which are originally disposed alone are integrally formed with the upper housing or the lower housing separately. Of course, the housing may be assembled from a left housing and a right housing along a left and right direction, which may be understood as that parts of the upper housing and the lower housing which are originally disposed alone are integrally formed with the left housing or the right housing separately. In addition, it is to be noted that specific components of the housing 10 in the present invention cannot limit the present invention.

The housing 10 is formed with an accommodation space 10a in which a fan 20 for generating a cooling airflow and a circuit board assembly 30 for implementing a charging function of the charger 100 are disposed. The fan 20 is disposed near the air inlet 15 and used for drawing air outside the housing 10 into the housing 10 via the air inlet 15 to generate the cooling airflow. The circuit board assembly 30 includes a circuit board 31, heating elements 32 disposed on the circuit board 31, and a heat dissipation member 33 connected to the heating elements 32 in a thermally conductive manner.

A printed circuit is disposed on the circuit board 31 and used for connecting, for example, resistors, capacitors, and corresponding semiconductor elements to implement the function of the charger 100. When energized, the heating elements 32 generate heat. Specifically, the heat generated by the heating elements 32 is greater than or equal to 0.1 kWh. The heating elements 32 are electrically connected to the circuit board 31. Multiple heating elements 32 of different types and different specifications may be disposed in the charger 100. In some examples, the heating elements 32 may be power semiconductor devices or transformers such as field-effect transistors and may be provided with weld legs to be welded onto the circuit board 31.

The heat dissipation member 33 is connected to the heating elements 32 in the thermally conductive manner to transfer out the heat generated by the heating elements 32 when energized. In some examples, the heat dissipation member 33 may be implemented in the form of a heat sink which may be a whole plate or multiple separate plates. Of course, thermal conduction among the separate plates is cut off, and an optimal heat dissipation effect cannot be achieved. At least a part of the heat dissipation member 33 is in contact with surfaces of the multiple heating elements 32, and the heat generated by the multiple heating elements 32 is conducted to the heat dissipation member 33 according to the principle of thermal conduction and then dissipated under the action of the cooling airflow. In general, to enhance the heat dissipation effect of the heat dissipation member 33, a surface of the heat dissipation member 33 in contact with the multiple heating elements 32 is designed to have a plate structure so that a maximum contact area between the heat dissipation member 33 and the multiple heating elements 32 is obtained. In addition, one end of the heat dissipation member 33 is configured to be in the shape of a comb so that a maximum heat dissipation area is obtained. The heat dissipation member 33 may be disposed in the housing 10 of the charger 100. Of course, the heat dissipation member 33 may be exposed from the housing 10 and implement a heat dissipation function as a part of the housing 10. It is to be noted that the function of the heat dissipation member 33 in this example is to transfer, with the good thermal conductivity of the heat dissipation member 33, the heat generated by the multiple heating elements 32 to air, the preceding material and shape of the heat dissipation member 33 cannot limit the present invention, and those skilled in the art should specifically configure the material and shape of the heat dissipation member 33 according to actual conditions.

In some examples, the charger 100 further includes a deflector 17 detachably disposed in the housing 10 and used for guiding a flow direction of the cooling airflow flowing into the housing 10 so that the heat dissipation efficiency of the charger 100 is improved. Specifically, the deflector 17 is disposed in the accommodation space 10a formed by the housing 10 and detachably connected to the upper housing 11. After the deflector 17 is fixedly mounted to the upper housing 11, the deflector 17, the lower housing 12, and part of the upper housing 11 constitute a heat dissipation channel 40 for the cooling airflow to flow through. It is to be noted that the deflector 17 in this example can be detachably connected to the upper housing 11 through assembly, and such design has the advantage of facilitating later maintenance such as reducing maintenance costs. On the other hand, the heat dissipation channel can be flexibly adjusted according to heat dissipation requirements so that different heat dissipation requirements are met. Of course, the deflector 17 may be configured to be integrally formed with the housing 10, which is not limited herein. The deflector 17 is configured to be made of the same material as the housing 10, such as plastics. Of course, the deflector 17 may be configured to be made of another material with good thermal conductivity, and the material of the deflector 17 is not limited in the present invention.

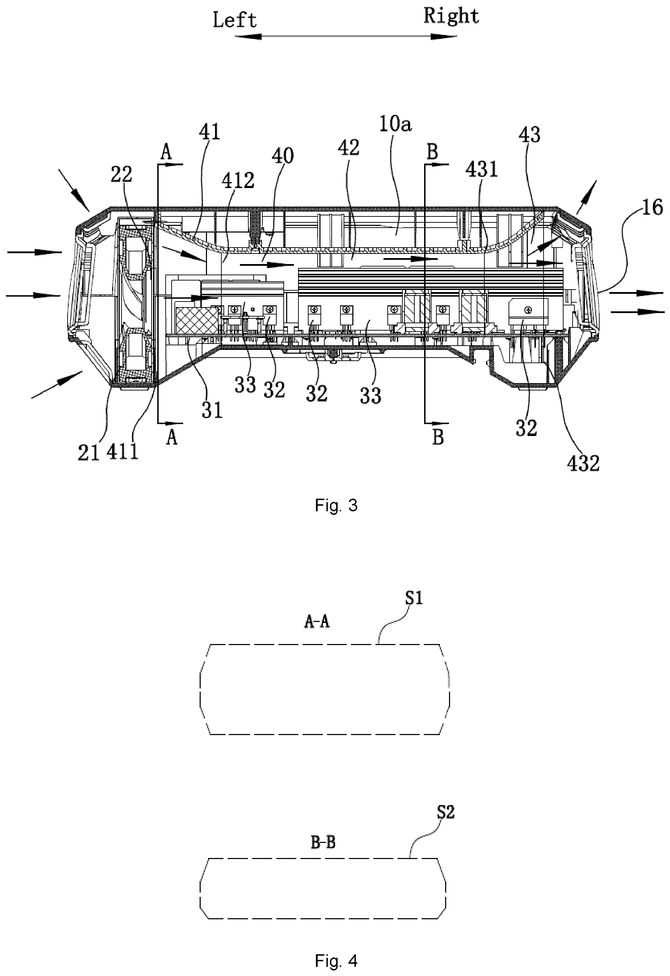

Referring to FIG. 3, the heat dissipation channel 40 has at least a first cross-sectional area S1 and a second cross-sectional area S2, where the first cross-sectional area S1 is larger than the second cross-sectional area S2 so that the cooling airflow which flows out of part of the heat dissipation channel having the first cross-sectional area S1 can accelerate to flow out of part of the heat dissipation channel having the second cross-sectional area, so as to dissipate the heat rapidly. It is to be understood that the preceding cross-sectional areas are substantially perpendicular to the flow direction of the cooling airflow. Specifically, the heat dissipation channel 40 includes a first channel 41, a second channel 42, and a third channel 43 which sequentially communicate with one another. When the charger 100 starts working, the fan 20 is started and the air outside the housing 10 enters the housing 10 from the air inlet 15, flows through the fan 20, sequentially passes through the first channel 41, the second channel 42, and the third channel 43, and then flows out from the air outlet 16, thereby constituting the cooling airflow which dissipates the heat in the space inside the housing 10. Directions of arrows in FIG. 3 show the flow direction of the cooling airflow. Specifically, the first channel 41 has a first port 411 facing the air inlet 15 and a second port 412 facing away from the air inlet 15, where the first port 411 has a larger cross-sectional area S1 than the second port 412. In other words, the first channel 41 is configured to be in the shape of a bell mouth, and the first port 411 has a larger caliber than the second port 412. The fan 20 has a fan air inlet 21 facing the air inlet 15 and a fan air outlet 22 facing away from the air inlet 15. The fan air outlet 22 is disposed opposite to the first port 411 of the first channel 41, and a cross-sectional area of the fan air outlet 22 is substantially the same as a cross-sectional area S1 of the first port 411. Specifically, to improve the heat dissipation efficiency of the charger 100, the cross-sectional area S1 of the first port 411 of the first channel 41 is set to be larger than a cross-sectional area of the second port 412 so that the cooling airflow can gradually accelerate in the first channel 41 and rapidly flow through the second channel 42, where a cross-sectional area S2 of the second channel 42 remains substantially unchanged and is substantially the same as the cross-sectional area of the second port 412 of the first channel 41. In some examples, to improve the heat dissipation effect of the charger 100, the heat dissipation channel 40 is configured to be a relatively closed space, which refers to that there are no other air inlets or air outlets through which the airflow can flow except the first port 411 and a fourth port 432. The heat dissipation channel 40 is configured to be relatively closed, which has the advantage that after the cooling airflow flowing out from the fan air outlet 22 enters the first channel 41, the first channel 41 in the shape of the bell mouth can cause pressure of the airflow in the first channel 41 to gradually increase and the airflow to accelerate through the second channel 42 and rapidly carry the heat generated by the circuit board assembly 30 out of the housing 10. The fan 20 and the first channel 41 in this example are sequentially disposed from left to right. It is to be noted that the fan 20 may be partially disposed in the first channel 41 and it is the most important to ensure that almost all of the cooling airflow flowing out from the fan air outlet 22 can flow into the heat dissipation channel 40. Therefore, the fan 20 may be disposed on a left side of the first channel 41 or partially overlap the first channel 41.

In some examples, the fan 20 may be disposed near the air outlet 16. When the charger 100 starts working, the fan 20 is started and under the action of the fan 20, the air outside the housing 10 enters the housing 10 from the air inlet 15, sequentially passes through the first channel 41, the second channel 42, and the third channel 43, flows through the fan 20, and finally flows out from the air outlet 16. After entering the housing 10 from the air inlet 15, the cooling airflow directly enters the heat dissipation channel 40. Since the cross-sectional area of the first port 411 of the first channel 41 is larger than the cross-sectional area of the second port 412, the cooling airflow gradually accelerates in the first channel 41 to rapidly flow through the second channel 42 and carry away the heat on the circuit board assembly 30.

The circuit board assembly 30 is at least partially disposed in the second channel 42. Specifically, the heating elements 32 and the heat dissipation member 33 connected to the heating elements 32 in the thermally conductive manner are at least partially disposed in the second channel 32. In this manner, the cooling airflow enters the housing 10 from the air inlet 15, passes through the fan 20, flows through the first channel 41, enters the second channel 42, takes away the heat on the circuit board assembly 30 at least partially disposed in the second channel 42, flows through the third channel 43, and finally flows out of the housing 10 from the air outlet 16. Specifically, the third channel 43 has a third port 431 away from the air outlet 16 and the fourth port 432 close to the air outlet 16, where a cross-sectional area of the third port 431 is substantially the same as the cross-sectional area of the second channel 42, a cross-sectional area of the fourth port 432 is larger than the cross-sectional area of the third port 431, and further, the cross-sectional area of the fourth port 432 is smaller than or equal to the cross-sectional area of the first port 411. In this example, a ratio of the cross-sectional area of the fan air outlet 22 to the cross-sectional area of the second channel 42 is greater than or equal to 1 and less than or equal to 2. Specifically, the ratio of the cross-sectional area of the fan air outlet 22 to the cross-sectional area of the second channel 42 is 1.4. The cross-sectional area of the fan air outlet 22 is defined as an area of a circle having a blade of the fan 20 as a radius.

The charger 100 in this example is particularly suitable for charging battery packs of the large power tools or battery packs with large capacities. Output power of the charger in this example ranges from 1200 W to 1600 W. It is to be understood that the charger 100 has relatively high output power, the circuit board assembly 30 inevitably generates a relatively large amount of heat when energized, and therefore, the fan 20 for generating the cooling airflow must have a relatively high rotational speed to generate a large amount of air, causing noise with a relatively great influence. Specifically, when the output power of the charger 100 in this example can be as high as 1600 W, in order that the heat can be better dissipated so as to ensure that the charger can charge the battery pack normally and safely, preferably, the blade of the fan 20 has a diameter of 120 mm, and the rotational speed of the fan 20 is higher than or equal to 2000 rpm and lower than or equal to 3000 rpm. When the fan 20 rotates at a high speed, after the air enters the housing 10 from the air inlet 15, relatively loud noise is generated on the blade and a nearby inner wall of the housing due to the high-speed flow of the air, affecting user experience.

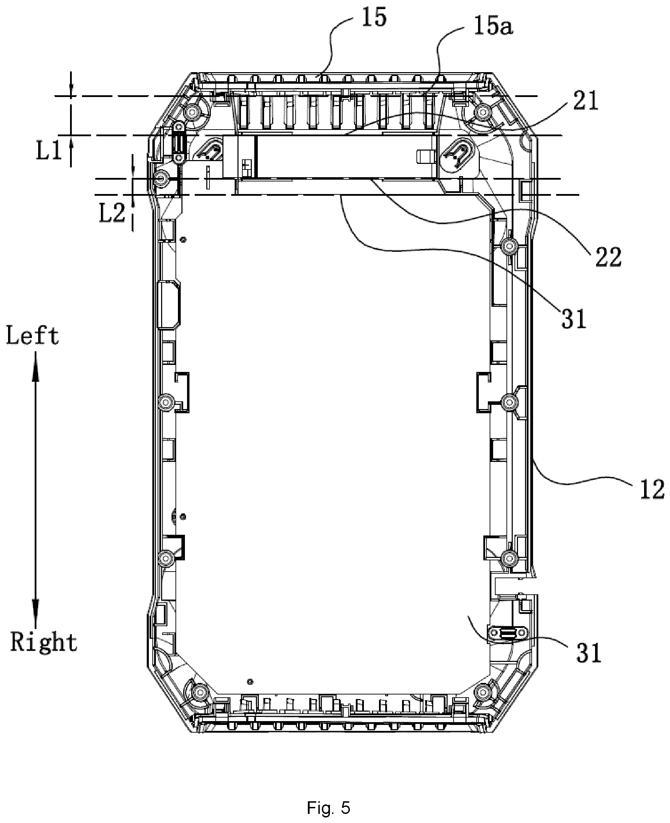

In some examples, referring to FIGS. 5 and 6, the fan 20 includes an outer fan frame 23 arranged along a radial direction of the fan 20 and used for fixedly mounting the fan 20 to the housing 10. A shock-absorbing material 25 such as rubber or foam is wrapped on an outer side of the outer fan frame 23. When the fan 20 rapidly rotates, in particular, when the airflow impinges on the fan 20 rapidly, the shock-absorbing material can reduce the vibration of the fan 20 to a certain extent, thereby reducing the noise.

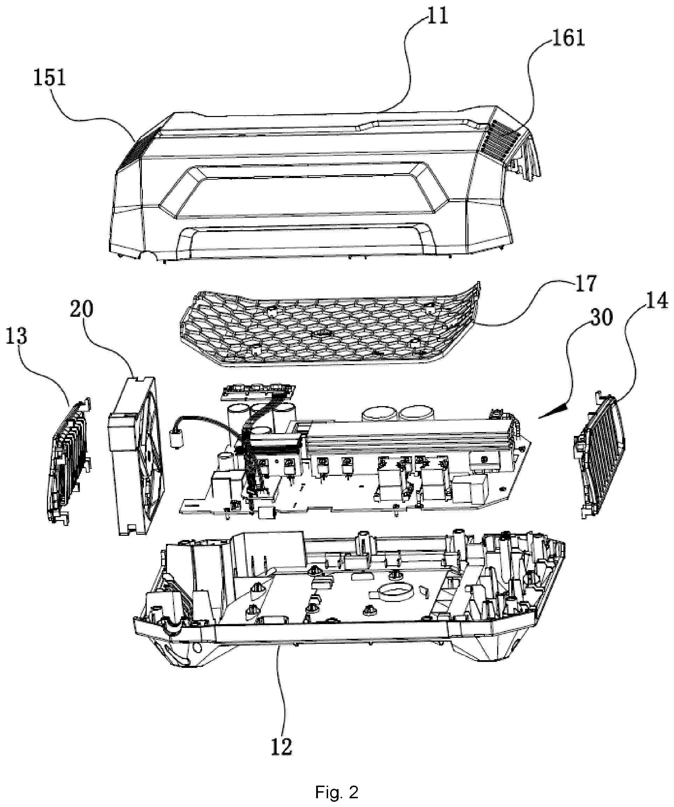

In some examples, referring to FIGS. 1 and 2, the charger 100 further includes multiple second air inlets 151 disposed on the left housing 13 and a second air outlet 161 disposed on the right housing 14. Specifically, the multiple second air inlets 151 are disposed above and below the air inlet 15 separately, and the second air outlet 161 is disposed above the air outlet 16. Referring to FIG. 3, after entering the housing 10 from the air inlet 15 and the second air inlets 151 separately, the airflow gathers together, passes through the fan air inlet 21 of the fan 20, and then enters the heat dissipation channel 40. The air inlet structure designed above can avoid the following case to a large extent: after flowing into the housing 10 and before flowing into the fan air inlet 21, the cooling airflow flows without being guided and thus relatively loud noise is generated due to friction between the cooling airflow and the inner wall of the housing 10.

In this example, a distance between the fan air inlet 21 and an inner wall 15a of the housing in the left and right direction is L1, where the inner wall 15a of the housing is disposed opposite to the air inlet 15. L1 can also be considered as a distance between the fan air inlet 21 and the air inlet 15. A blade 24 of the fan 20 has a diameter D1, and when a ratio of the diameter D1 of the blade to the distance L1 is greater than or equal to 6, the charger 100 generates lowest noise in operation. It is to be noted that it is relatively proper that the preceding ratio relationship is applicable to the case where only one fan is provided. In some other examples, multiple fans 20 are provided. In this case, those skilled in the art need to set a proper distance L1 according to actual conditions. The preceding distance L1 may be obtained through simulation or a relatively proper distance L1 may be obtained through data of multiple tests so that the charger 100 has less noise interference in operation. Further, in this example, a distance L1 between the fan air inlet 21 and the air inlet 15 in the left and right direction is set to be greater than or equal to 15 mm, the diameter D1 of the blade 24 is set to be 80 mm, and a distance L2 between the fan air outlet 22 and the circuit board 31 in the left and right direction is set to be greater than or equal to 10 mm. The charger 100 designed in this manner, in particular, the charger with the function of high-power output, can ensure a compact structure and low noise and has a relatively good heat dissipation effect and relatively good user experience so that on the basis of the own noise of the fan, the charger 100 can control, in the working process, the overall noise to be in a range of 10 dB or lower.

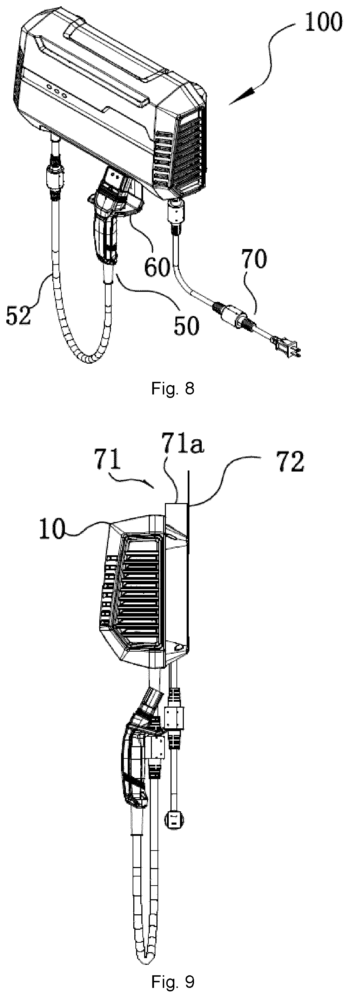

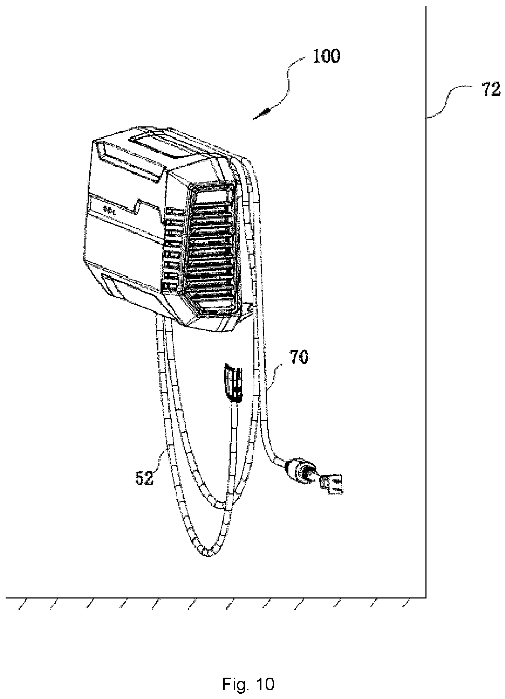

In some examples, referring to FIGS. 7 to 10, the charger 100 may be used for charging various power tools such as the riding mower 200. The riding mower 200 has a battery pack 210 and a tool interface 220 for charging. The charger 100 further includes a charging device 50, a storage assembly 60 for storing the charging device 50, and a power cable 70. Specifically, the power cable 70 is used for receiving external power supplies such as mains electricity so as to charge the power tools. Preferably, the charging device 50 is in the form of a charging gun and electrically connected to the circuit board assembly in the charger 100 through a charging cable 52. The storage assembly 60 serves as a component where the gun is hung, so as to avoid damage caused by the random placement of the charging device 50. The charging device 50 is electrically connected to the tool interface 220 of the power tool so that converted electrical energy accessed by the power cable 70 is transmitted to the power tool and used for charging the power tool. The charger 100 may also be fixedly mounted to a wall by the storage assembly 60. The housing 10 of the charger 100 and a wall 72 form a winding portion 71 for storing the power cable 70 or the charging cable 52. Specifically, the winding portion 71 has an accommodation space 71a capable of accommodating cables. In some special charging conditions, the power cable 70 or the charging cable 52 is relatively long. When the charger 100 is mounted onto and hung from the wall, an excessively long cable falls on the ground, easily trips a user up, and also affects aesthetics. The user may wind the excessively long cable on the charger 100 along the winding portion 71 and arrange the excessively long cable in the accommodation space 71a.

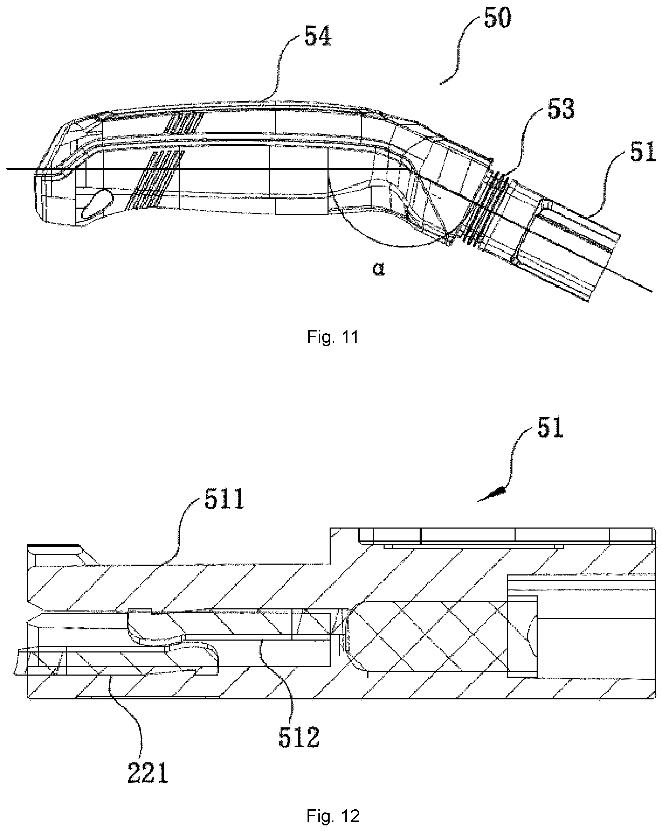

In some examples, referring to FIG. 11, the charging device 50 further includes a charging terminal 51, a grip 54, and a sealing ring 53 disposed on the charging terminal 51. When the user needs to charge the power tool, the user may hold the grip 54 of the charging device 50 and plug into the power tool. Specifically, in order that the user feels better when holding the charging device 50, it is set that an included angle α between an extension direction of the grip 54 and an extension direction of the charging terminal 51 ranges from 140° to 160°. Further, it is set that the included angle α between the extension direction of the grip 54 and the extension direction of the charging terminal 51 is 153°. When the charging terminal 51 of the charger 100 is inserted into the tool interface 220 of the power tool, the sealing ring 53 disposed between the grip 54 and the charging terminal 51 can better seal the charging terminal 51 in the tool interface 220 of the power tool, so as to prevent moisture from entering the charging terminal 51 under working conditions such as rain and thus avoid a safety hazard.

Referring to FIG. 12, the charging terminal 51 includes a charging connection piece 512 disposed in a rubber casing 511. Specifically, the charging terminal 51 has the structure of an elastic piece, which has a high current-carrying capability and a good contact and can be prevented from falling off in a charging process. Specifically, when the charging terminal 51 is inserted into the tool interface 220 of the power tool, a tool connection piece 221 in the tool interface and the charging connection piece 512 are elastically deformed under the action of an external force and then engaged with each other in a snap-fit manner, so as to avoid the case where the charging terminal 51 disengages from the tool interface 220 of the power tool in the charging process, ending the charging unexpectedly and affecting the use of the user.

## Claims

1. A charger, comprising:
a housing (10) formed with an air inlet (15) and an air outlet (16);
a fan (20) disposed in the housing and used for generating a heat dissipation airflow entering from the air inlet and flowing out from the air outlet; and
a circuit board assembly (30) comprising at least heating elements which generate heat when energized;
wherein a heat dissipation channel (40) for the heat dissipation airflow to flow through is provided in the housing and comprises at least a first channel (41), a second channel (42) and a third channel (43), sequentially communicating with each other, the heat dissipation airflow sequentially flowing through the first channel, the second channel, and the third channel,
at least part of the heating elements are disposed in the second channel, and a cross-sectional area of a first port (411) of the first channel facing the air inlet is larger than a cross-sectional area of the second channel so that the heat dissipation airflow flowing through the first channel is capable of accelerating through the second channel;
**characterized in that**
the first to third channels are aligned along a rotation axis of the fan.

2. The charger according to claim 1, wherein the first channel further comprises a second port facing away from the air inlet and the first port has a larger cross-sectional area than the second port.

3. The charger according to claim 2, wherein the fan is disposed between the air inlet and the second port of the first channel.

4. The charger according to claim 1, wherein the third channel comprises a third port away from the air outlet and a fourth port close to the air outlet, and the fourth port is disposed opposite to the air outlet.

5. The charger according to claim 4, wherein the fourth port of the third channel has a larger cross-sectional area than the third port of the third channel.

6. The charger according to claim 4, wherein the cross-sectional area of the first port of the first channel is larger than or equal to a cross-sectional area of the fourth port of the third channel.

7. The charger according to claim 1, further comprising a deflector (17) disposed in the housing and detachably connected to the housing.

8. The charger according to claim 7, wherein the deflector and the housing form the heat dissipation channel for guiding a flow direction of the heat dissipation airflow flowing into the housing.

9. The charger according to claim 8, wherein the fan has a fan air inlet facing the air inlet and a fan air outlet facing away from the air inlet, and approximately all of the heat dissipation airflow flowing out from the fan air outlet flows out of the heat dissipation channel.

10. The charger according to claim 1, wherein the fan comprises an outer fan frame for fixedly mounting the fan to the housing, and a shock-absorbing material is wrapped on an outer side of the outer fan frame.

11. The charger according to claim 1, wherein a ratio of a diameter of a blade of the fan to a distance between the fan air inlet and the air inlet is greater than or equal to 6.

12. The charger according to claim 1, wherein the circuit board assembly comprises a circuit board and a heat dissipation member, the circuit board is provided with a printed circuit, and the heat dissipation member is connected to the heating elements in a thermally conductive manner and used for dissipating the heat generated by the heating elements.

13. The charger according to claim 12, wherein the heating elements are power semiconductor devices or transformers, and the heat generated by the heating elements in a working process of the charger is greater than 0.1 kWh.

14. The charger according to claim 1, wherein output power of the charger is higher than or equal to 1200 W and lower than or equal to 1600 W.

15. The charger according to claim 1, wherein the charger further comprises a charging device (50), the charging device comprises a charging gun for connection with a tool interface (220) of a riding mower (200) and a charging cable (52) for connecting the charging gun to a body of the charger.

## Patentansprüche

1. Ladegerät, umfassend:
ein Gehäuse (10), das mit einem Lufteinlass (15) und einem Luftauslass (16) ausgebildet ist;
einen Lüfter (20), der im Gehäuse angeordnet ist und zur Erzeugung eines Wärmeableitungs-Luftstroms dient, der vom Lufteinlass eintritt und aus dem Luftauslass austritt; und
eine Leiterplattenanordnung (30), die zumindest Heizelemente umfasst, welche beim Einschalten Wärme erzeugen;
wobei ein Wärmeableitungskanal (40) für den Durchfluss des Wärmeableitungs-Luftstroms im Gehäuse vorgesehen ist und zumindest einen ersten Kanal (41), einen zweiten Kanal (42) und einen dritten Kanal (43) umfasst, die nacheinander miteinander kommunizieren, wobei der Wärmeableitungs-Luftstrom nacheinander durch den ersten Kanal, den zweiten Kanal und den dritten Kanal strömt,
wobei zumindest ein Teil der Heizelemente im zweiten Kanal angeordnet ist, und wobei ein Querschnittsbereich einer ersten Öffnung (411) des ersten Kanals, die dem Lufteinlass zugewandt ist, größer ist als ein Querschnittsbereich des zweiten Kanals, so dass der durch den ersten Kanal strömende Wärmeableitungs-Luftstrom durch den zweiten Kanal beschleunigt werden kann;
**dadurch gekennzeichnet, dass**
die ersten bis dritten Kanäle entlang einer Rotationsachse des Lüfters ausgerichtet sind.

2. Ladegerät nach Anspruch 1, wobei der erste Kanal ferner eine zweite Öffnung umfasst, die vom Lufteinlass abgewandt ist, und wobei die erste Öffnung einen größeren Querschnittsbereich aufweist als die zweite Öffnung.

3. Ladegerät nach Anspruch 2, wobei der Lüfter zwischen dem Lufteinlass und der zweiten Öffnung des ersten Kanals angeordnet ist.

4. Ladegerät nach Anspruch 1, wobei der dritte Kanal eine dritte Öffnung, die vom Luftauslass entfernt ist, und eine vierte Öffnung, die in der Nähe des Luftauslasses liegt, umfasst, wobei die vierte Öffnung der Luftauslassöffnung gegenüberliegt.

5. Ladegerät nach Anspruch 4, wobei die vierte Öffnung des dritten Kanals einen größeren Querschnittsbereich aufweist als die dritte Öffnung des dritten Kanals.

6. Ladegerät nach Anspruch 4, wobei der Querschnittsbereich der ersten Öffnung des ersten Kanals größer oder gleich einem Querschnittsbereich der vierten Öffnung des dritten Kanals ist.

7. Ladegerät nach Anspruch 1, ferner umfassend ein Strömungsleitelement (17), der im Gehäuse angeordnet und lösbar mit dem Gehäuse verbunden ist.

8. Ladegerät nach Anspruch 7, wobei das Strömungsleitelement und das Gehäuse den Wärmeableitungskanal bilden, um eine Strömungsrichtung des in das Gehäuse strömenden Wärmeableitungs-Luftstroms zu führen.

9. Ladegerät nach Anspruch 8, wobei der Lüfter einen Lüfterlufteinlass aufweist, der dem Lufteinlass zugewandt ist, und einen Lüfterluftaustritt, der vom Lufteinlass abgewandt ist, und wobei nahezu der gesamte aus dem Lüfterluftaustritt austretende Wärmeableitungs-Luftstrom aus dem Wärmeableitungskanal austritt.

10. Ladegerät nach Anspruch 1, wobei der Lüfter einen äußeren Lüfterrahmen umfasst, um den Lüfter fest am Gehäuse zu montieren, und wobei ein stoßdämpfendes Material an einer Außenseite des äußeren Lüfterrahmens angebracht ist.

11. Ladegerät nach Anspruch 1, wobei ein Verhältnis eines Durchmessers eines Lüfterblatts zu einem Abstand zwischen dem Lüfterlufteinlass und dem Lufteinlass größer oder gleich 6 ist.

12. Ladegerät nach Anspruch 1, wobei die Leiterplattenanordnung eine Leiterplatte und ein Wärmeableitungselement umfasst, wobei die Leiterplatte mit einer gedruckten Schaltung versehen ist und das Wärmeableitungselement thermisch leitend mit den Heizelementen verbunden ist und zur Ableitung der von den Heizelementen erzeugten Wärme dient.

13. Ladegerät nach Anspruch 12, wobei die Heizelemente Leistungs-Halbleiterbauelemente oder Transformatoren sind, und die bei einem Arbeitsprozess des Ladegeräts von den Heizelementen erzeugte Wärme größer als 0,1 kWh ist.

14. Ladegerät nach Anspruch 1, wobei eine Ausgangsleistung des Ladegeräts größer oder gleich 1200 W und kleiner oder gleich 1600 W ist.

15. Ladegerät nach Anspruch 1, wobei das Ladegerät ferner eine Ladeeinrichtung (50) umfasst, wobei die Ladeeinrichtung eine Ladestation zum Anschluss an eine Werkzeug-Schnittstelle (220) eines Aufsitzmähers (200) und ein Ladekabel (52) zum Anschluss der Ladestation an ein Gehäuse des Ladegeräts umfasst.

## Revendications

1. Un chargeur, comprenant :
un boîtier (10) formé avec une entrée d'air (15) et une sortie d'air (16) ;
un ventilateur (20) disposé dans le boîtier et utilisé pour générer un flux d'air de dissipation thermique entrant par l'entrée d'air et sortant par la sortie d'air ; et
un ensemble carte de circuit imprimé (30) comprenant au moins des éléments chauffants qui génèrent de la chaleur lorsqu'ils sont alimentés ;
dans lequel un canal de dissipation thermique (40) destiné à laisser passer le flux d'air de dissipation thermique est prévu dans le boîtier et comprend au moins un premier canal (41), un deuxième canal (42) et un troisième canal (43) communiquant séquentiellement entre eux, le flux d'air de dissipation thermique traversant successivement le premier canal, le deuxième canal et le troisième canal,
au moins une partie des éléments chauffants étant disposée dans le deuxième canal, et une surface de section transversale d'un premier orifice (411) du premier canal faisant face à l'entrée d'air étant plus grande qu'une surface de section transversale du deuxième canal, de manière que le flux d'air de dissipation thermique traversant le premier canal puisse s'accélérer dans le deuxième canal ;
**caractérisé en ce que**
les premier à troisième canaux sont alignés le long d'un axe de rotation du ventilateur.

2. Le chargeur selon la revendication 1, dans lequel le premier canal comprend en outre un second orifice orienté à l'opposé de l'entrée d'air, et dans lequel le premier orifice a une surface de section transversale plus grande que celle du second orifice.

3. Le chargeur selon la revendication 2, dans lequel le ventilateur est disposé entre l'entrée d'air et le second orifice du premier canal.

4. Le chargeur selon la revendication 1, dans lequel le troisième canal comprend un troisième orifice éloigné de la sortie d'air et un quatrième orifice proche de la sortie d'air, le quatrième orifice étant disposé en face de la sortie d'air.

5. Le chargeur selon la revendication 4, dans lequel le quatrième orifice du troisième canal a une surface de section transversale plus grande que celle du troisième orifice du troisième canal.

6. Le chargeur selon la revendication 4, dans lequel la surface de section transversale du premier orifice du premier canal est supérieure ou égale à la surface de section transversale du quatrième orifice du troisième canal.

7. Le chargeur selon la revendication 1, comprenant en outre un déflecteur (17) disposé dans le boîtier et raccordé de manière amovible audit boîtier.

8. Le chargeur selon la revendication 7, dans lequel le déflecteur et le boîtier forment le canal de dissipation thermique destiné à guider une direction d'écoulement du flux d'air de dissipation thermique entrant dans le boîtier.

9. Le chargeur selon la revendication 8, dans lequel le ventilateur présente une entrée d'air orientée vers l'entrée d'air du boîtier et une sortie d'air orientée à l'opposé, et dans lequel la quasi-totalité du flux d'air de dissipation thermique sortant de la sortie d'air du ventilateur s'échappe du canal de dissipation thermique.

10. Le chargeur selon la revendication 1, dans lequel le ventilateur comprend un cadre externe destiné à le fixer au boîtier, et un matériau amortisseur de chocs est enroulé autour de la face externe du cadre externe.

11. Le chargeur selon la revendication 1, dans lequel un rapport entre un diamètre d'une pale du ventilateur et une distance entre l'entrée d'air du ventilateur et l'entrée d'air du boîtier est supérieur ou égal à 6.

12. Le chargeur selon la revendication 1, dans lequel l'ensemble carte de circuit imprimé comprend une carte de circuit et un élément de dissipation thermique, la carte de circuit comportant un circuit imprimé, et l'élément de dissipation thermique étant connecté aux éléments chauffants de manière thermiquement conductrice et étant utilisé pour dissiper la chaleur générée par les éléments chauffants.

13. Le chargeur selon la revendication 12, dans lequel les éléments chauffants sont des dispositifs semi-conducteurs de puissance ou des transformateurs, et la chaleur générée par les éléments chauffants pendant un processus de fonctionnement du chargeur est supérieure à 0,1 kWh.

14. Le chargeur selon la revendication 1, dans lequel la puissance de sortie du chargeur est supérieure ou égale à 1200 W et inférieure ou égale à 1600 W.

15. Le chargeur selon la revendication 1, dans lequel le chargeur comprend en outre un dispositif de charge (50), le dispositif de charge comprenant un pistolet de charge destiné à être connecté à une interface d'outil (220) d'une tondeuse autoportée (200) et un câble de charge (52) destiné à connecter le pistolet de charge à un corps du chargeur.
